# EUROPÄISCHE PATENTANMELDUNG

(11) **EP 2 410 576 A2**
(43) Veröffentlichungstag der Anmeldung: **25.01.2012**
(21) Anmeldenummer: 11169284.4
(22) Anmeldetag: 09.06.2011
(51) Int. Cl.: H01L 31/048, B60K 16/00, B32B 17/10

(54) **Verbundbauteil mit einer solaraktiven Schicht und Verfahren zur Herstellung eines Verbundbauteils**

(30) Priorität: 22.07.2010 DE 102010031639
(71) Anmelder: Bayerische Motoren Werke Aktiengesellschaft, 80809 München (DE)
(72) Erfinder: Mohr, Philipp, 84030 Ergolding (DE)

(57) **Zusammenfassung**

Die vorliegende Erfindung betrifft ein Verbundbauteil, insbesondere zur Verwendung als Außenhautbauteil eines Fahrzeugs, mit: einem Schichtaufbau (11), der eine der Sonne zugewandte erste Seite (11 a) und eine der Sonne abgewandte zweite Seite (11b) aufweist, und eine Mehrzahl von Schichten (10, 20, 30, 40, 50, 60, 70, 80, 90) umfasst, wobei eine an der Sonne zugewandten Seite (11a) des Schichtaufbaus angeordnete erste Schicht eine solaraktiven Schicht (10) ist, die eine der Sonne zugewandte erste Seite (10a) und eine der Sonne abgewandte zweite Seite (10b) aufweist, wobei der Schichtaufbau (11) zumindest teilweise von einer Matrix (12) umgeben ist, sowie ein Verfahren zur Herstellung des Verbundbauteils.

## Beschreibung

Die Erfindung betrifft ein Verbundbauteil, insbesondere zur Verwendung als Außenhautbauteil eines Fahrzeugs, mit einem Schichtaufbau, der eine der Sonne zugewandte erste Seite und eine der Sonne abgewandte zweite Seite aufweist, und eine Mehrzahl von Schichten umfasst, von denen zumindest eine Schicht eine solaraktive Schicht ist, die eine der Sonne zugewandte erste Seite und eine der Sonne abgewandte zweite Seite aufweist, wobei der Schichtaufbau zumindest teilweise von einer Matrix umgeben ist, sowie ein Verfahren zur Herstellung eines solchen Verbundbauteils.

Bei aus der Praxis bekannten Verbundbauteilen, von denen die Erfindung ausgeht, werden Solarmodule auf ein formstabiles Trägerteil, beispielsweise aus Glas, Stahl oder Thermoplast aufgeklebt, um als Strukturbauteil für Fahrzeuge verwendet zu werden. Darüber hinaus ist es auch bekannt, Solarzellen auf eine dünne Stahlfolie oder eine Thermoplastträgerfolie aufzubringen, die zum Schutz vor Umwelteinflüssen durch Schutzschichten geschützt werden müssen. Ein typischer Lagenaufbau besteht darin, dass eine äußere Schutzfolie vorgesehen ist, die über eine Klebefolie mit einer Außenfläche des Solarmoduls verbunden ist sowie, dass auf der dazu gegenüberliegenden Außenfläche des Solarmoduls über eine Klebefolie eine weitere Schutzfolie aufgebracht ist. Ein solcher Sandwich-Aufbau wird in einem Laminator zusammengefügt.

Derartige Vorrichtungen weisen jedoch den Nachteil auf, dass aufgrund der schweren Solarmodule bzw. der schweren Stahlfolien sich ein hohes Gesamtgewicht der Baugruppe ergibt, was zu hohem Kraftstoffverbrauch sowie hohem Schadstoffausstoß des Fahrzeugs führt. Bei der Herstellung der Solarmodule mittels Laminierung von Solarzellen auf verschiedenen Trägermaterialien wirken sich darüber hinaus die langen Zykluszeiten nachteilig auf die Prozessdauer aus. Ferner sind diese Vorrichtung nur mit zweidimensional gewölbten äußeren Flächen realisierbar.

Demgegenüber liegt der Erfindung die Aufgabe zugrunde, ein Verbundbauteil anzugeben, das die Nachteile des im vorgehenden beschriebenen Stand der Technik überwindet sowie ein Verfahren zur Herstellung eines solchen Verbundbauteils anzugeben.

Zur Lösung dieser Aufgabe lehrt die Erfindung eine Vorrichtung sowie ein Verfahren mit den Merkmalen der unabhängigen Ansprüche.

Besonders zu bevorzugende Ausführungsformen und Weiterbildungen der Erfindung sind Gegenstand der Unteransprüche.

Gemäß der Erfindung kann ein Verbundbauteil, insbesondere zur Verwendung als Außenhautbauteil eines Fahrzeugs, einen Schichtaufbau, der eine der Sonne zugewandte erste Seite und eine der Sonne abgewandte zweite Seite aufweist, und eine Mehrzahl von Schichten umfasst, von denen zumindest eine Schicht eine solaraktive Schicht ist, die eine der Sonne zugewandte erste Seite und eine der Sonne abgewandte zweite Seite aufweist, wobei der Schichtaufbau zumindest teilweise von einer Matrix umgeben ist, aufweisen. Weiterhin kann die solaraktive Schicht zumindest abschnittsweise aus einem Solartextil ausgebildet sein. Hieraus ergibt sich der Vorteil, dass durch Verwendung eines Solartextils in einem RTM-Prozess (Resin-Transfer-Moulding-Prozess) oder im Nasspressverfahren ein besonders leichtes sowie strukturell hinreichend stabiles Verbundbauteil herstellbar ist. Dabei kann die solaraktive Schicht eine erste Schicht sein, die an der zur Sonne zugewandten Seite des Schichtaufbaus angeordnet ist.

Weiterhin kann die solaraktive Schicht im Wesentlichen flexibel sein. Dies bietet den Vorteil, dass das Verbundbauteil auch in sicherheitskritischen Bereichen des Fahrzeugs Verwendung finden kann. Als Beispiel soll hier der Frontbereich eines Kraftfahrzeuges, insbesondere die Motorhaube, genannt werden, an die hohe Anforderungen in Bezug auf die Nachgiebigkeit beim sogenannten Fußgänger-Crash gestellt werden.

Weiterhin kann zwischen der Sonne zugewandten Seite und der Sonne abgewandten Seite der Schichtaufbau, die solaraktive Schicht, eine Isolierschicht, zur elektrischen Isolation gegenüber leitenden weiteren Schichten, wobei die Isolierschicht insbesondere aus Glasflies ausgebildet ist, aufweisen. Darüber hinaus kann eine erste Faserverbundschicht vorgesehen sein, wobei diese insbesondere als ein Gelege aus kohlefaserverstärktem Kunststoff, aus glasfaserverstärktem Kunststoff und/oder aus Naturfaser, insbesondere Basalt, Hanf und/oder Sisal, ausgebildet ist. Zusätzlich kann der Schichtaufbau eine erste Gewebeschicht, eine Flieshilfe, eine zweite Gewebeschicht, und/odereine zweite Faserverbundschicht, wobei diese insbesondere als ein Gelege aus kohlefaserverstärktem Kunststoff, aus glasfaserverstärktem Kunststoff und/oder aus Naturfaser, insbesondere Basalt, Hanf und/oder Sisal ausgebildet ist, aufweisen. Die Flieshilfe hat die Aufgabe sicher zu stellen, dass beim späteren Umgießen bzw. Umspritzen des Schichtaufbaus mit einer Matrix, eine ausreichende Durchtränkung der einzelnen Lagen mit der Matrix gewährleistet ist. Dabei leitet die Flieshilfe die Matrix zu den jeweiligen Lagen.

Weiterhin kann der Schichtaufbau formgebend für das Verbundbauteil sein.

Darüber hinaus kann das Verbundbauteil als Dachmodul, Motorhaube, Kofferraumhaube, Tür, Kotflügel, Cabriolet-Hardtop, oder als Anbauteil, insbesondere Luftleiteinrichtung oder Seitenspiegelverkleidung eines Fahrzeugs ausgebildet sein.

In einem weiteren Aspekt betrifft die Erfindung ein Verfahren zur Herstellung eines Verbundbauteils, insbesondere als Außenhautbauteil für Fahrzeuge, das die Schritte, Bereitstellen eines Schichtaufbaus der eine Mehrzahl von Schichten umfasst wobei eine solaraktive Schicht an einer der Sonne zugewandten ersten Seite des Sichtaufbaus angeordnet wird, Überführen des Schichtaufbaus in eine vorbestimmte Form, Injektion einer Matrix derart, dass der Schichtaufbau zumindest abschnittsweise mit der Matrix überzogen und/oder durchtränkt wird, wodurch ein Verbundbauteil erzeugt wird und Aushärten des Verbundbauteils, aufweisen kann.

Darüber hinaus kann zum Überführen des Schichtaufbaus in eine vorbestimmte Form dieses in ein Vorformwerkzeug eingebracht werden und die Formgebung mittels eines Wärmeofens erfolgen. Alternativ hierzu kann der Schichtaufbau auch mittels Nasspressverfahren in eine vorbestimmte Form überführt werden.

Zusätzlich kann der vorgeformte Schichtaufbau in eine Kavität einer RTM-Anlage zur Injektion einer Matrix aus Harz und Härter eingebracht werden, wobei die Matrix aus Harz und/oder Härter ausgebildet ist.

Darüber hinaus kann das Aushärten des Verbundbauteils unter Raumtemperatur oder mittels Vortemperierung zumindest eines Werkzeugs der RTM-Anlage erfolgen.

Im Folgenden wird die Erfindung anhand lediglich Ausführungsbeispiele darstellende Zeichnungen ausführlicher erläutert. Es zeigen in schematischer Darstellung:

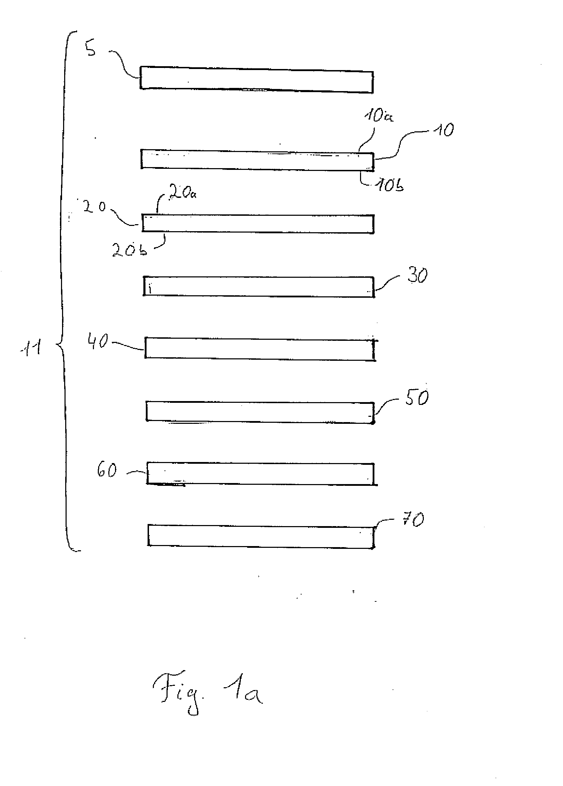

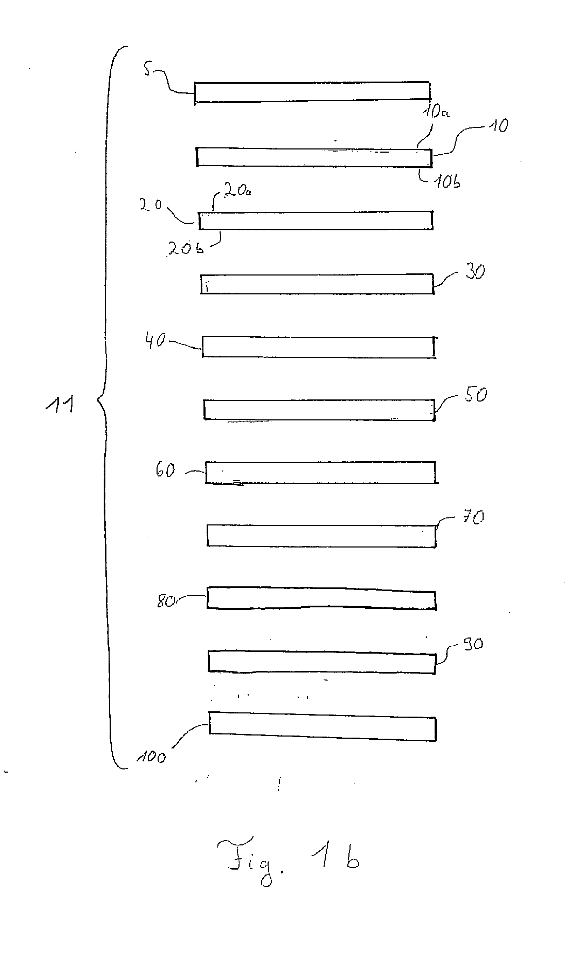

- Figur 1 a: eine seitliche Explosionsansicht eines Verbundbauteils gemäß einer ersten Ausführungsform der Erfindung,
- Figur 1 b: eine seitliche Explosionsansicht eines Verbundbauteils gemäß einer zweiten Ausführungsform der Erfindung und
- Figur 2: eine seitliche Schnittansicht eines Verbundbauteils gemäß der ersten Ausführungsform der vorliegenden Erfindung.

Eine erste Ausführungsform des erfindungsgemäßen Verbundbauteils 1 ist schichtweise aufgebaut, dessen Struktur beispielsweise in Figur 1a dargestellt ist und anhand deren erklärt werden soll. Der übliche, aus dem Stand der Technik bekannte Standard-Aufbau eines Schichtaufbaus umfasst eine erste Faserverbundschicht 30, eine erste Gewebeschicht 40, eine Fließhilfe 50, eine zweite Gewebeschicht 60 und eine zweite Faserverbundschicht 70. Somit entsprechen die untersten fünf Schichten des Aufbaus, der in Figur 1 a dargestellt ist, dem Stand der Technik. Erfindungsgemäß wird oberhalb der ersten Faserverbundschicht 30 eine solaraktive Schicht 10 vorgesehen. Diese solaraktive Schicht 10 umfasst eine der Sonne zugewandte erste Seite 10a sowie eine der Sonne abgewandte zweite Seite 10b. Bei dem erfindungsgemäßen Verbundbauteil 1 ist die solaraktive Schicht 10 als Solartextil ausgebildet, mit der zur Stromgewinnung aus der auf das Bauteil einwirkenden Sonnenenergie elektrische Energie erzeugbar ist. Das Solartextil ist dabei aus Fasermatten bzw. Fasergeweben aufgebaut. Solche Solartextilien sind aus dem Stand der Technik bekannt, beispielsweise aus den Veröffentlichungen *MIT's work on solar textiles in architectural design, led by Sheila Kennedy,* oder *Power Textiles, a spin off from Heriot Watt University.* Ein weiterer Aufbau eines solchen Solartextils ist aus Development of flexible solar cells on textiles von Prof. John 1. B. Wilson, Photovoltaics Beyond Conventional Silicon, Dresden, April 2009, bekannt.

Die Faserverbundschichten 30 und 70 können beispielsweise aus CFK-Gelegen (kohlefaserverstärkten Kunststoffen), GFK-Gelegen (glasfaserverstärkten Kunststoffen) oder aus Naturfaser (Basalt, Hanf, Sisal) ausgebildet sein. Die Faserverbundschichten 30, 70 können alternativ aus den genannten Materialien auch als Gewebe, Gelege und/oder als wirre Faseranordnung gebildet sein.

Sofern für die erste Faserverbundschicht 30 ein elektrisch leitendes Material, wie beispielsweise ein CFK-Gelege, verwendet wird, muss zwischen dem Solartextil 10 und der ersten Verbundschicht 30 eine Isolierschicht 20 vorgesehen werden. Diese Isolierschicht 20 weist ein der solaraktiven Schicht 10 zugewandten Seite 20a und eine der ersten Faserverbundschicht 30 zugewandten zweite Seite 20b auf und kann beispielsweise aus Glasflies ausgebildet sein. Es kann prinzipiell jedoch jedes beliebige, elektrisch isolierende Material verwendet werden, zur Ausbildung der isolierenden Schicht.

In einer weiteren Alternative der ersten Ausführungsform kann eine Schutzschicht 5 oberhalb der solaraktiven Schicht 10 in dem Schichtaufbau 11 eingebracht sein, durch die eine Außenfläche der solaraktiven Schicht 10 abgedeckt wird. Die Schutzschicht 5 fungiert dabei als Barriereschicht bzw. Barrierefolie und verhindert das Eindringen und Entweichen von Wasserdampf, Sauerstoff und UV-Licht. Vorteilhafterweise weist die Schutzschicht 5 ETFE (Ethylen-Tetrafluorethylen-Copolymer), PE (Polyethylen), EVOH (Ethylenvinylalkohol), PCTFE (Polychlortrifluorethylen), PVC (Polyvinyichlorid), PVdC (Polyvinylidenchlorid), PETE (Polyethylenterephthalat), FEP (Fluor-Propylen-Ethylen), Klarlack oder Glas auf. Die Schutzsicht muss dabei transparent sein, um zu gewährleisten, dass Licht zu der solaraktiven Schicht 10 gelangen kann.

Eine weitere Ausführungsform der vorliegenden Erfindung ist in Figur 1b dargestellt. Gleiche Bezugszeichen wie in Figur 1a bezeichnen dabei gleiche Bauteile. Diese zweite Ausführungsform ist um zwei weitere Schichten 80 und 90 gegenüber der ersten Ausführungsform erweitert, um einen möglichst symmetrischen Schichtaufbau zu realisieren. Bei unsymmetrischem Schichtaufbau kann sich aufgrund unterschiedlicher, thermischer Ausdehnungskoeffizienten der einzelnen Schichten ein Verzug des Gesamtbauteils ergeben. Um solche, nicht erwünschte Deformationen zu verhindern wird ein symmetrischer Aufbau angestrebt. Die Schicht 80 hat dabei im Wesentlichen die gleichen Materialeigenschaften hinsichtlich Schrumpfung und Steifigkeit wie die Isolierschicht 20. Analog dazu hat die Schicht 90 im Wesentlichen die gleichen Materialeigenschaften hinsichtlich Schrumpfung und Steifigkeit wie die solaraktive Schicht 10. Die Füeßhilfe 50 ist in dieser Ausführungsform die mittlere, neutrale Schicht.

In einer weiteren Alternative der zweiten Ausführungsform kann eine Schutzschicht 5 oberhalb der solaraktiven Schicht 10 in dem Schichtaufbau 11 eingebracht sein, durch die eine Außenfläche der solaraktiven Schicht 10 abgedeckt wird. Die Schutzschicht 5 fungiert dabei als Barriereschicht bzw. Barrierefolie und verhindert das Eindringen und Entweichen von Wasserdampf, Sauerstoff und UV-Licht. Vorteilhafterweise weist die Schutzschicht 5 ETFE (Ethylen-Tetraffuorethylen-Copofymer), PE (Polyethylen), EVOH (Ethylenvinylalkohol), PCTFE (Polychlortrifluorethylen), PVC (Polyvinyfchlorid), PVdC (Polyvinylidenchlorid), PETE (Polyethylenterephthalat), FEP (Fluor-Propylen-Ethylen) oder Glas auf. Um einen symmetrischen Aufbau zu realisieren wird auf der gegenüberliegenden Seite des Schichtaufbaus 11 eine weitere Schicht 100 vorgesehen, die im Wesentlichen die gleichen Materialeigenschaften aufweist, wie die Schutzschicht 5.

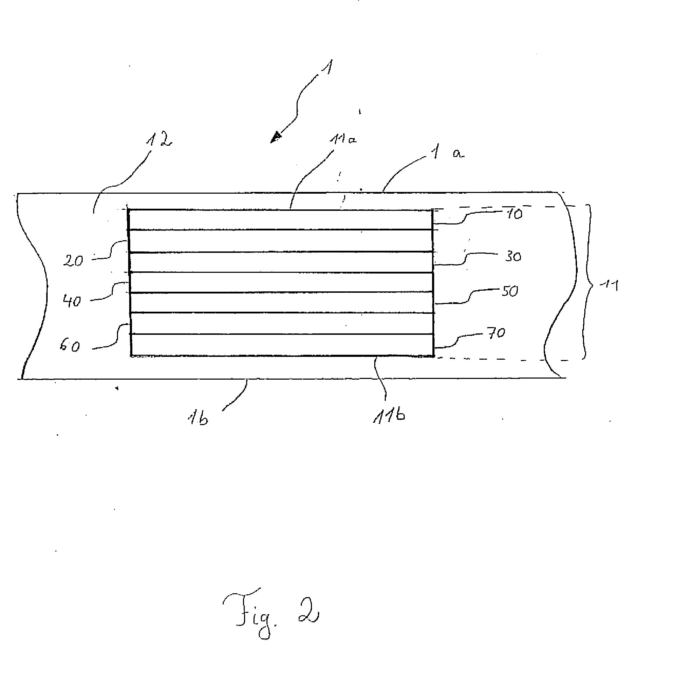

Die Figur 2 zeigt eine seitliche Schnittansicht des erfindungsgemäßen Verbundbauteils 1, wobei der Schichtaufbau 11 mit einer Matrix 12 umgossen bzw. umspritzt ist. Die Figur 2 zeigt nur beispielhaft einen Schichtaufbau gemäß der ersten Alternative der ersten Ausführung der Erfindung. Analog hierzu kann jedoch auch ein Verbundbauteil 1 erzeugt werden, in dem ein Schichtaufbau 11 gemäß der zweiten Alternative der ersten Ausführungsform, sowie beider Alternativen der zweiten Ausführungsform der Erfindung, wie in Figur 1b gezeigt, mit einer Matrix 12 umspritzt wird.

Im Folgenden soll mit Bezug auf die Figuren 1a und 2 ein Verfahren zur Herstellung eines Verbundbauteils der oben beschriebenen Art erläutert werden. Dabei wird von einem RTM-Verfahren ausgegangen, dass ein Harzinjektionsverfahren ist, mit welchem Bauteile mit einem Faservolumengehalt von ca. 50 % hergestellt werden können. In einem ersten Schritt müssen die verwendeten Faserhalbzeuge in Form gebracht werden. Dazu wird ein Schichtaufbau 11 bzw. ein Gewebeverbund gemäß der ersten oder zweiten Ausführungsform der Erfindung, bereitgestellt. In einem Vorwerkzeug werden die zumindest einseitig mit Binder, insbeondere Thermoplastbinder versehenen textilen Halbzeuge, d.h. die Schichten 10, 20, 30, 40, 50, 60 und 70 erwärmt, so dass der daran angeordnete Binder aktiviert wird. Der Binder liegt pulverisiert vor und wird auf mindestens eine oder auch auf beide Seiten jeder Schicht 10, 20, 30, 40, 50, 60, 70, 80, 90 aufgebracht. Durch Erwärmen und Verpressen schmilzt der Binder auf und verbindet die einzelnen losen Schichten miteinander zu dem Schichtaufbau 11. Anschließend werden die Faserhalbzeuge in ein Formgebungswerkzeug bzw. eine Preform-Anlage bzw. Vorformwerkzeug eingebracht, zur Formung der Halbzeuge bzw. zur Erstellung des Preformlings. Dabei kühlt der Binder ab und verfestigt sich, wobei der Schichtaufbau 11 in eine vorbestimmte Form überführt wird.

Der so entstandene Preformling bzw. Vorformling wird anschließend aus der Preform-Anlage entnommen und in die Kavität einer offenen RTM-Anlage gelegt, wonach diese geschlossen wird. Bei geschlossener Anlage wird in einem Injektionsprozess eine Matrix aus Harz und Härter bzw. Trennmittel unter Druck injiziert. Dabei kann die geschlossene Form temperiert werden. Aus dem Schichtaufbau 11 und der Matrix 12 wird das Verbundbauteil 1 erzeugt.

Die anschließende Aushärtung der Matrix kann unter Raumtemperatur oder mit Vortemperierung erfolgen, wobei Werkzeugtemperaturen von 80 bis 100°C verwendet werden. Dieser Prozessschritt hat den Vorteil, dass die Aushärtung der Matrix beschleunigt wird.

Alternativ hierzu kann das Verbundbauteil 1, mit dem beschriebenen Schichtaufbau auch im Nasspressverfahren hergestellt werden.

Im Folgenden werden weitere Herstellungsverfahren genannten, zum Herstellen des Erfindungsgemäßen Verbundbauteils. Diese Verfahren können alternativ zu den oben genannten RTM- oder Nasspress- Verfahren durchgeführt werden.

Das Handlaminieren ist das älteste, einfachste und am weitesten verbreitete Verfahren. Es genügen minimale technische Voraussetzungen, weshalb es hauptsächlich für kleinere Serien, einfachere Bauteilgeometrien und für den Formenbau anwendbar ist. Die Formen dazu werden ebenfalls handlaminiert. Bei Verwendung von Formenharzen lassen sich hohe Oberflächengüten erreichen. Die Aushärtung erfolgt fast immer drucklos bei Raumtemperatur. Erhöhte Temperaturen bei der Aushärtung sind nur dann erforderlich, wenn Formen und Bauteile später einer höheren Wärmebelastung ausgesetzt sind (> ca. 60 °C). Das Handlaminieren erfolgt in den Schritten:
1. Auftragen eines Trennmittels auf die Formoberfläche.
2. Einstreichen- oder spritzen einer Deckschicht auf Epoxyd- oder Polyesterbasis (z.B. UP-Vorgelat).
3. Nach dem Angelieren der Deckschicht (wird auch als Fein- schicht oder Gelcoat bezeichnet) werden die nachfolgenden Gewebelagen schichtweise naß-in-naß aufgebracht. Deckschichten aus UP-Vorgelat werden über Nacht durchgehärtet, bevor mit Epoxydharz weiterlaminiert wird. Zum Laminieren wird zunächst eine Harzschicht aufgetragen. Danach werden die Gewebeverstärkungen eingelegt und sorgfältig mit Harz durchtränkt. Als Werkzeuge dienen vor allem Pinsel und Rillenroller/Velourwalzen.
4. Den Abschluss bildet oft ein Abreißgewebe. Das aus Nylonfasern bestehende Gewebe lässt sich nach dem Aushärten des Harzes abschälen ("abreißen") und erzeugt dabei eine definiert rauhe, saubere und klebfreie Oberfläche zur weiteren Verarbeitung (z.B. zum Verkleben).
5. Die Aushärtung der Laminate erfolgt meist drucklos bei Raumtemperatur. Lediglich bei öptimierten Leichtbauteilen, vor allem Sandwichbauteilen mit einem leichten Kern aus Schaum oder Waben, wird im Vakuum unter Druck gehärtet. Die Bauteile werden entweder in der Form oder nach dem Entformen zusätzlich getempert. Die hierfür erforderlichen Temperaturen liegen, je nach Harzsystem, meist bei 50 - 230 °C.
6. Nach der vollständigen Durchhärtung der Teile erfolgt die weitere Bearbeitung, z.B. durch Besäumen, Schleifen, Kleben.

Als Matrix (Bettungsmasse) werden flüssige Harze verarbeitet, vor allem Epoxyd- und Polyesterharze. Zur Verstärkung eigenen sich die speziell für diesen Zweck hergestellten und oberflächenbehandelten Glas-, Aramid- und Kohlefasern. Diese werden in einer Vielzahl geeigneter textiler Produkte angeboten. Die wichtigsten sind Rovings, Gewebe, Gelege, Bänder, Schläuche, Litzen, Vliese, Matten und Schnitzel.

Der erreichbare Faservolumengehalt liegt bei Mattenlaminaten ca. 15 - 20 Vol.-%, bei Geweben ca. 40 - 50 Vol.-%. min. 20 °C Raumtemperatur, Luftfeuchtigkeit um 60 %.

Beim Vakuumpressen wird das zuvor handlaminierte Bauteil mit der Form in einen Foliensack geschoben (nur bei kleinen Teilen möglich) oder mit einer Folie abgedeckt, die am Formenrand luftdicht aufgeklebt wird. Durch Absaugen der Luft presst sich die Folie auf das Laminat und drückt es gegen die Form. Der max. erreichbare Druck ist der Umgebungs-Luftdruck und beträgt ca. 1 bar. Das Vakuumpressen wird vor allem angewandt um: den Faseranteil des Laminates zur erhöhen, also um überschüssiges Harz herauszudrücken; leichte Stützstoffe wie z.B. Schaumkunststoffe oder Waben mit hochfesten Deckschichten aus Harz und Gewebe zu verkleben und so ein extrem leichtes und steifes Bauteil herzustellen. Um diese Ergebnisse zu erzielen, muss das Bauteil mit gleichmäßigem Druck gepreßt werden. Dazu wird das Laminat zunächst mit Abreißgewebe und einer nichthaftenden Lochfolie abgedeckt. Darauf wird ein luftdurchlässiges Vlies gelegt, das die Aufgabe hat, das Vakuum gleichmäßig zu verteilen und überschüssiges Harz aus dem Laminat aufzusaugen. So wird ein hoher und gleichmäßiger Fasergehalt im Bauteil erzielt.

Die Formen werden beim Vakuumieren nicht besonders hoch belastet, so dass sie wie schon beim Handlaminierverfahren relativ leicht aufgebaut sein können.Die Aushärtung erfolgt meist bei Raumtemperatur. Eine anschließende Temperung der Bauteile ist, wie schon bei Handlaminaten, noch in der Form oder nach dem Entformen möglich.

Das Autoklav-Verfahren ist eines der teuersten und aufwendigsten Verarbeitungsverfahren. Es wird in der Regel nur beim Einsatz von Prepregs angewandt. Prepregs sind mit einem speziellen Harz vorimpregnierte (Preimpregnated) und "angehärtete" Verstärkungsgewebe.Aus Prepregs lassen sich komplizierte, mechanisch und thermisch hochbelastbare Bauteile pressen. Der Faservolumengehalt liegt dabei über 60 %, der Luftporengehalt ist äußerst gering. Das Autoklafv-Verfahren weist folgende Arbeitsschritte auf:
1. Ablegen der einzelnen Prepreg-Lagen (manuell oder mittels Tapelegemaschine)
2. Abdecken mit Lochfolie, Saugvlies und Vakuumfolie
3. Vakuum anlegen (Dichtheit prüfen)
4. Aufbau in den Autoklaven bringen
5. Aushärten unter Druck und hoher Temperatur
6. Abkühlen
7. Belüften und Entnehmen

Während beim "normalen" Vakuumverfahren ein max. Druck von 1 bar erreicht wird (nämlich der Umgebungsluftdruck) kann der Autoklav, der ja ein Druckgefäß darstellt, einen Druck von > 6 bar auf das Laminat bringen. Um Prepregs aushärten zu können, wird im Autoklav üblicherweise eine Temperatur von 170 °C erzeugt. Für die Herstellung großer, sphärisch geformter CFK-Bauteile werden meist CFK-Formen verwendet, da aufgrund der annähernd gleichen thermischen Ausdehnungskoeffizienten von Form und Bauteil der Verzug der Bauteile äußerst gering ist.

Beim Wickelverfahren werden die Verstärkungsfasern auf einen Positivkern aufgewickelt. Dieses Verfahren eignet sich vorwiegend zur Herstellung rotationssymmetrischer Bauteile wie Behälter, Rohre und Wellen. Mit mehrachsig bewegbaren Fadenführungen können auch kompliziertere Bauteile wie z.B. Rohrkrümmer gewickelt werden. Man unterscheidet zwischen Drehmaschinen, Taumel- und Planeten-Wickelverfahren. Eine Wickelmaschine besteht aus einer Drehvorrichtung für die Rotationsbewegung des Wickelkerns, einer Fadenführung, einem Harz-Tränkbad und einem Spulenständer für den Roving (Faserstrang). Als Matrix (Bettungsmasse) werden niedrigviskose Epoxyd- und Polyesterharze verarbeitet. Zur Verstärkung werden hauptsächlich Rovings, zum Teil auch Bänder verwendet. Die Wickelkerne sind je nach Bauteilgeometrie: wiederverwendbar (leicht konisch); verlorene Kerne (verbleiben im Bauteil, bestehen meist aus Metall oder Kunststoff); auswaschbar bzw. herauslösbar (Spezialgips, Schaumstoffe).

Das Preßverfahren ist für die Herstellung von FVW-Teilen in großen Stückzahlen geeignet. Die Reproduzierbarkeit ist gut, die Fertigung weitgehend automatisierbar, die Taktzeiten sind gering. Benötigt wird eine hydraulische Oberkolben-Kurzhubpresse mit Steuerung. Geeignete Materialien sind hauptsächlich Glasfasern in Form von Matten und Geweben sowie Aramid- und Kohlenstoff-Filamentgewebe in Verbindung mit Epoxydund Polyesterharzen. Man unterscheidet: SMC (Sheet Moulding Compound), BMC (Bulk Moulding Compound), und GMT (Glasmattenverstärktes Thermoplast).Übliche Verfahren sind Heißpreßtechnik, Kaltpreßtechnik, Naß-Preßverfahren, Prepreg-Preßverfahren und Heißpreßtechnik. Es werden beheizbare, hartverchromte und polierte Metallwerkzeuge eingesetzt.

Beim Naß-Preßverfahren werden trockene Verstärkungsmaterialien (Gewebe, Gelege, Matten oder Vorformlinge) in die Form eingelegt. Danach wird eine abgewogene Menge Harzes eingegossen oder injiziert. Die Schließgeschwindigkeit des Werkzeuges wird so gewählt, dass ein Aufreißen der Glasverstärkung infolge hoher Strömungsgeschwindigkeit des Harzes vermieden wird. Die Werkzeugtemperatur beträgt je nach Art des Harzes 90 - 140 °C, der Preßdruck auf dem Bauteil 5 - 25 bar.

Beim Prepreg-Verfahren werden vorimprägnierte Verstärkungsmaterialien verarbeitet. Zur Herstellung flächiger Bauteile mit konstanter Wandstärke werden Matten- und Gewebeprepregs (GMT, SMC) verwendet, für Formteile mit unterschiedlichen oder scharf abgesetzten Wandstärken Preßmassen (BMC). Die Verarbeitungsbedingungen sind z.B. beim SMC: Preßdruck 20 - 250 bar und Temperatur 140-160 °C.

Durch die erfindungsgemäße Vorrichtung bzw. durch das erfindungsgemäße Verfahren kann unter Verwendung einer solaraktiven textilen Schicht 10 ein dreidimensionales Leichtbausolarpanel erzeugt werden. Dabei können neben der Dachpartie eines Fahrzeugs auch andere Außenhaufibauteife mit dieser Technologie erzeugt werden, wie beispielsweise die Frontklappe bzw. Motorhaube. Würde man hierfür herkömmliche Solarzellen nutzen, müsste man diese hinter Glas schützen. Aus Fußgängerschutzgründen wäre der Einsatz im Bereich der Frontklappe jedoch nicht möglich. Die vorliegende Erfindung ermöglicht jedoch auch die Verwendung von Solarzellen in Luftleitelementen, wie beispielsweise Heckspoilern oder Dachspoilern, die der Sonneneinstrahlung besonders exponiert sind und dadurch eine besonders günstige Sonnenenergieausbeute aufweisen.

Durch die Verwendung von CFK-Geweben von dünnschichtiger Solartextilien kann ferner das Gewicht dieser Verbundteile wesentlich reduziert werden, so dass pro Kilometer eine Treibstoff- sowie Schadstoffausstoßeinsparung realisierbar ist.

## Patentansprüche

1. Verbundbauteil, insbesondere zur Verwendung als Außenhautbauteil eines Fahrzeugs, mit:
- einem Schichtaufbau (11), der eine der Sonne zugewandte erste Seite (11a) und eine der Sonne abgewandte zweite Seite (11 b) aufweist, und eine Mehrzahl von Schichten (10, 20, 30, 40, 50, 60, 70, 80, 90) umfasst, von denen zumindest eine Schicht eine solaraktive Schicht (10) ist, die eine der Sonne zugewandte erste Seite (10a) und eine der Sonne abgewandte zweite Seite (10b) aufweist,
- wobei der Schichtaufbau (11) zumindest teilweise von einer Matrix (12) umgeben ist,
**dadurch gekennzeichnet, dass**
- die solaraktive Schicht (10) zumindest abschnittsweise aus einem Solartextil ausgebildet ist.

2. Vorrichtung nach Anspruch 1, **dadurch gekennzeichnet, dass**
- die solaraktive Schicht (10) im Wesentlichen flexibel ist.

3. Vorrichtung nach einem der vorhergehenden Ansprüche, **dadurch gekennzeichnet, dass**
- zwischen der Sonne zugewandten Seite (11 a) und der Sonne abgewandten Seite (11 b) der Schichtaufbau (11),
- die solaraktive Schicht (10),
- eine Isolierschicht (20), zur elektrischen Isolation gegenüber leitenden weiteren Schichten (30, 40, 50, 60, 70, 80, 90), wobei die Isolierschicht (20) insbesondere aus Glasflies ausgebildet ist,
- eine erste Faserverbundschicht (30), wobei diese insbesondere als ein Gelege aus kohlefaserverstärktem Kunststoff, aus glasfaserverstärktem Kunststoff und/oder aus Naturfaser, insbesondere Basalt, Hanf und/oder Sisal, ausgebildet ist,
- eine erste Gewebeschicht (40),
- eine Flieshilfe (50),
- eine zweite Gewebeschicht (60), und/oder
- eine zweite Faserverbundschicht (70), wobei diese insbesondere als ein Gelege aus kohlefaserverstärktem Kunststoff, aus glasfaserverstärktem Kunststoff und/oder aus Naturfaser, insbesondere Basalt, Hanf und/oder Sisal ausgebildet ist, aufweist.

4. Vorrichtung nach einem der vorhergehenden Ansprüche, **dadurch gekennzeichnet, dass**
- der Schichtaufbau (11) formgebend ist für das Verbundbauteil.

5. Vorrichtung nach einem der vorhergehenden Ansprüche, **dadurch gekennzeichnet, dass**
- das Verbundbauteil als Dachmodul, Motorhaube, Kofferraumhaube, Tür, Kotflügel, Anbauteil insbesondere Luftleiteinrichtung oder Seitenspiegelverkleidung, eines Fahrzeugs ausgebildet ist.

6. Verfahren zur Herstellung eines Verbundbauteils, insbesondere als Auf3enhautbauteil für Fahrzeuge, mit den Schritten:
- Bereitstellen eines Schichtaufbaus der eine Mehrzahl von Schichten (10, 20, 30, 40, 50, 60, 70, 80, 90) umfasst wobei eine solaraktive Schicht (10) an einer der Sonne zugewandten ersten Seite (11 a) des Sichtaufbaus (11) angeordnet wird,
- Überführen des Schichtaufbaus (11) in eine vorbestimmte Form,
- Injektion einer Matrix (12) derart, dass der Schichtaufbau (11) zumindest abschnittsweise mit der Matrix (12) überzogen und/oder durchtränkt wird wodurch ein Verbundbauteil erzeugt wird und
- Aushärten des Verbundbauteils.

7. Verfahren nach Anspruch 6, **dadurch gekennzeichnet dass**
- zum Überführen des Schichtaufbaus (11) in eine vorbestimmte Form, dieser in ein Vorformwerkzeug eingebracht wird.

8. Verfahren nach einem der vorhergehenden Ansprüche, **gekennzeichnet durch** den Schritt:
- Einbringen des vorgeformten Schichtaufbaus (11) in eine Kavität einer RTM-Anlage zur Injektion der Matrix (12), wobei die Matrix aus Harz und/oder Härter ausgebildet ist.

9. Verfahren nach einem der vorhergehenden Ansprüche, **dadurch gekennzeichnet, dass**
- das Aushärten des Verbundbauteils unter Raumtemperatur oder mittels Vortemperierung zumindest eines Werkzeugs der RTM-Anlage erfolgt.
